# EUROPEAN PATENT APPLICATION

(11) **EP 4 506 184 A1**
(43) Date of publication of application: **12.02.2025**
(21) Application number: 23778004.4
(22) Date of filing: 23.03.2023
(51) Int. Cl.: B44C 5/04, H05K 5/03, G02B 5/18

(54) **TEXTURE STRUCTURE, COVER PLATE, MOBILE TERMINAL, AND PREPARATION METHOD FOR COVER PLATE**

(30) Priority: 01.04.2022 CN 202210347758
(71) Applicant: BYD Company Limited, Shenzhen, Guangdong 518118 (CN)
(72) Inventor: ZHU, Qiyu, Shenzhen, Guangdong 518118 (CN); ZHAO, Lihong, Shenzhen, Guangdong 518118 (CN); LUO, Wenhai, Shenzhen, Guangdong 518118 (CN); DUAN, Feifei, Shenzhen, Guangdong 518118 (CN); ZHANG, Aodong, Shenzhen, Guangdong 518118 (CN)
(74) Representative: Gunzelmann, Rainer
(86) International application number: PCT/CN2023/083415
(87) International publication number: WO 2023/185635

(57) **Abstract**

A texture structure (100), a cover plate, a mobile terminal, and a preparation method for the cover plate. The texture structure (100) includes a substrate (10), and a plurality of groups of gratings (20) provided on one side of the substrate (10). The plurality of groups of gratings (20) are arranged on the surface of the substrate (10) in a crisscross pattern, wherein each group of gratings (20) includes a plurality of grating units (21) arranged side by side and extending in the same direction, and each grating unit (21) is configured to have a grating surface (30) inclined to the substrate (10).

## Description

### CROSS-REFERENCE TO RELATED APPLICATIONS

The present disclosure claims priority to Chinese Patent Application No. 202210347758.7 filed on April 1, 2022 and titled "Texture Structure, Cover Plate, Mobile Terminal and Cover Plate Preparation Method", which is incorporated herein by reference in its entirety.

### FIELD

The present disclosure relates to the field of optical technology, and in particular, to a texture structure, a cover plate, a mobile terminal, and a method for preparing the cover plate.

### BACKGROUND

At present, in order to improve the appearance of various products, various light and shadow effects are usually designed on the surface of the product. For example, in related technologies, the effect of mobile phone decoration textures is mostly flat light and shadow, and the changing light and shadow effects are reflected by color changes and light and shadow flow.

The color change of mobile phone decoration texture is mainly achieved through coating. After coating, it can only achieve the same color, or a simple gradient color, but it is a flat color from different angles, and the flow of light and shadow is mostly expressed through a single grating. The flow of light and shadow has no sense of fluctuation at different angles, and it also shows a flat two-dimensional light and shadow.

### SUMMARY

In view of this, the present disclosure provides a texture structure, a cover plate, a mobile terminal, and a preparation method of the cover plate. The texture structure can realize the light and shadow effect of a closed sand dune with a three-dimensional undulation.

The present disclosure provides a texture structure including:
substrate; and
a plurality of groups of gratings arranged on one side of the substrate, the plurality of groups of gratings are arranged on the surface of the substrate in a crisscross pattern, wherein each of the plurality of groups of gratings comprises a plurality of grating units arranged side by side and extending in the same direction, and each of the plurality of grating units is configured to have a grating surface inclined to the substrate.

According to an embodiment of the present application, the plurality of groups of gratings are configured to intersect so that a reflective surface of the texture structure in any direction exhibits a changing trend.

According to an embodiment of the present application, the plurality of gratings include curved gratings extending in a curved manner and/or straight line gratings extending in a straight line.

According to an embodiment of the present application, the plurality of groups of gratings include at least two groups of curved extended curved gratings.

According to an embodiment of the present application, the plurality of grating groups includes two groups of gratings, and at least one group of the two groups of gratings is a straight-line extending linear grating, and the slopes of the grating surfaces of the linear gratings are different in the extending direction.

According to an embodiment of the present application, a cross-section perpendicular to the extension direction of the grating is configured in a triangular or arcuate shape.

According to an embodiment of the present application, the tangent value of the angle between the grating surface and the surface of the substrate is between 1:150 and 20:1.

According to an embodiment of the present application, the tangent value of the angle between the grating surface of at least one set of gratings and the surface of the substrate is between 2:15 and 20:1, and/or, the tangent value of the angle between the grating surface of at least one set of gratings and the surface of the substrate is between 1:150 and 2:15.

According to an embodiment of the present application, an area where the orthographic projections of the plurality of groups of gratings on the substrate overlap is configured as an overlapping area, and a grating structure corresponding to the overlapping area is configured as an intersection, and the overlapping area has a plurality of position points A (x, y), the heights corresponding to the plurality of groups of intersecting gratings at each position point A (x, y) are h1, h2,..., hn respectively, the corresponding height H to the intersection at the corresponding position point A (x, y) is (h1 +h2 +...... +hn )/n, or the height H corresponding to the intersection at the corresponding position point A(x, y) is the smallest one among h1, h2,...,hn, where n is the plurality of gratings intersecting in the overlapping area.

According to an embodiment of the present application, the intersection is configured as a pyramid or a prism.

According to an embodiment of the present application, the texture structure has a plurality of intersections, and the shapes of the plurality of intersections are different.

According to a second aspect of the present disclosure, a cover plate is provided, including the texture structure provided by the present disclosure.

According to a third aspect of the present disclosure, a mobile terminal is provided, including the cover provided by the present disclosure.

According to a fourth aspect of the present disclosure, a method for preparing a cover plate is provided, the cover plate includes the texture structure provided by the present disclosure, and the preparation method includes:
Evenly apply photoresist on the glass plate, and perform photolithography exposure on the glass plate with the preset texture;
Transfer the preset photolithographic texture to the substrate; and
Attach the substrate to the cover.

In an embodiment, the substrate includes one of PC sheets, PET sheets, and PC/PMMA composite sheets.

According to a fifth aspect of the present disclosure, a method for preparing a cover plate is provided, the cover plate comprising a glass plate and a textured structure provided by the present disclosure, the glass plate is constructed as the substrate, and the preparation method includes:
Apply photoresist on the glass plate, and create a preset texture through exposure and development; and
The glass plate is placed into chemical solution for etching.

Through the above technical solution, multiple groups of gratings are arranged at intersections, so that areas where the plurality of groups of textures intersect can share the intersecting gratings, so that the entire texture structure has a closed and fused light and shadow effect. Moreover, the grating units of each group of gratings have inclined grating surfaces, which can achieve a three-dimensional undulating feeling. Combined with the closed light and shadow effect, the entire texture structure can achieve the effect of closed sand dunes, thus having a good visual effect.

Other features and advantages of the present disclosure will be described in detail in the detailed description that follows.

### BRIEF DESCRIPTION OF THE DRAWINGS

The accompanying drawings are used to provide a further understanding of the present disclosure and constitute a part of the specification. They are used to explain the present disclosure together with the following specific embodiments, but do not constitute a limitation of the present disclosure. In the attached picture:
Figure 1 is a schematic diagram of the texture structure of two sets of grating combinations provided by an exemplary embodiment of the present disclosure;
Figure 2 is a light and shadow trend chart in the embodiment of Figure 1;
Figure 3a is a schematic diagram of the refraction of light when the height of the grating surface changes;
Figure 3b is a schematic diagram of the refraction of light when the width of the grating surface changes;
Figure 4 is a schematic diagram of the texture structure of two sets of grating combinations provided by an exemplary embodiment of the present disclosure;
Figure 5 is a schematic diagram of the intersection of the texture structure corresponding to the embodiment of Figure 4;
Figure 6a is a schematic diagram of the effect after cutting the texture structure on the right side of Figure 4;
Figure 6b is a schematic diagram of the effect after cutting off the texture structure on the right side of Figure 4;
Figure 6c is a schematic diagram of the effect after cutting the texture structure in Figure 6b;
Figure 7 is a schematic diagram of the texture structure of two sets of grating combinations provided by an exemplary embodiment of the present disclosure;
Figure 8 is a schematic diagram of the intersection of the texture structure corresponding to the embodiment of Figure 7;
Figure 9a is a schematic diagram of the effect after cutting the texture structure on the right side of Figure 7;
Figure 9b is a schematic diagram of the effect after cutting off the texture structure on the right side of Figure 7;
Figure 9c is a schematic diagram of the effect after cutting the texture structure in Figure 9b;
Figure 10 is a schematic diagram of the texture structure of two sets of grating combinations provided by an exemplary embodiment of the present disclosure;
Figure 11 is a partial enlarged view A of Figure 10;
Figure 12 is a three-dimensional structural diagram corresponding to the figure in Figure 11;
Figure 13 is a cross-sectional view of the intersection in Figure 12;
Figure 14 is a schematic diagram of the texture structure of two sets of grating combinations provided by an exemplary embodiment of the present disclosure;
Figure 15 is a partial enlarged view B of Figure 14;
Figure 16 is a three-dimensional structural view corresponding to the figure in Figure 14;
Figure 17 is a schematic structural diagram of a first grating provided by an exemplary embodiment of the present disclosure;
Figure 18a is an embodiment of cross-sectional view A of the first grating in Figure 17;
Figure 18b is another embodiment of the cross-sectional view A of the first grating in Figure 17;
Figure 19a is an embodiment of cross-sectional view B of the first grating in Figure 17;
Figure 19b is another embodiment of the cross-sectional view B of the first grating in Figure 17;
Figure 20 is a schematic structural diagram of a second grating provided by an exemplary embodiment of the present disclosure;
Figure 21a is an embodiment of the cross-sectional view C of the second grating in Figure 20;
Figure 21b is another embodiment of the cross-sectional view C of the second grating in Figure 20;
Figure 22a is an embodiment of the cross-sectional view D of the second grating in Figure 20;
Figure 22b is another embodiment of the cross-sectional view D of the second grating in Figure 20;
Figure 23a is a first embodiment of a schematic bottom view of a grating unit provided by an exemplary embodiment of the present disclosure;
Figure 23b is a second embodiment of a schematic bottom view of a grating unit provided by an exemplary embodiment of the present disclosure;
Figure 23c is a third embodiment of a schematic bottom view of a grating unit provided by an exemplary embodiment of the present disclosure;
Figure 23d is a fourth embodiment of a schematic bottom view of a grating unit provided by an exemplary embodiment of the present disclosure;
Figure 24a is a first embodiment of the extending direction of the grating provided by an exemplary embodiment of the present disclosure;
Figure 24b is a second embodiment of the extending direction of the grating provided by an exemplary embodiment of the present disclosure;
Figure 24c is a third embodiment of the extending direction of the grating provided by an exemplary embodiment of the present disclosure;
Figure 24d is a fourth embodiment of the extending direction of the grating provided by an exemplary embodiment of the present disclosure;
Figure 25 is a schematic structural diagram of a cover provided by an exemplary embodiment of the present disclosure;
Figure 26 is a flow chart of a method for preparing a cover plate according to an exemplary embodiment of the present disclosure;
FIG. 27 is a flow chart of a method for manufacturing a cover plate according to an exemplary embodiment of the present disclosure.

### DETAILED DESCRIPTION

Specific embodiments of the present disclosure will be described in detail below with reference to the accompanying drawings. It should be understood that the specific embodiments described here are only used to illustrate and explain the present disclosure, and are not intended to limit the present disclosure.

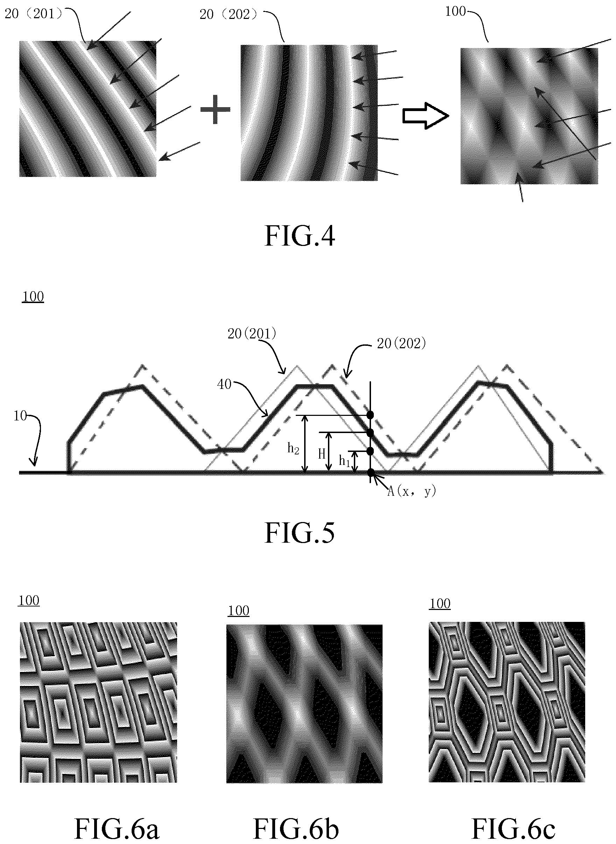

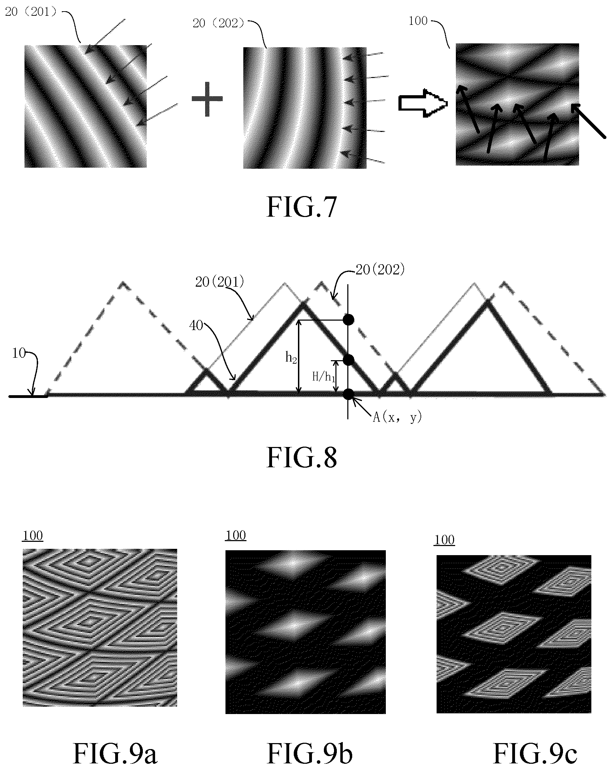

In this disclosure, unless otherwise specified, locative words such as "upper, lower, top, bottom" are generally directions of grating based on substrate as bottom surface. For details, please refer to the drawing directions in Figures 5 and 8. "Inside and outside" refers to the outline of the corresponding component. Terms used in this disclosure, such as "first, second", etc., are used to distinguish one element from another element and do not have sequence or importance. Furthermore, when the following description refers to the drawings, the same numbers in different drawings represent the same or similar elements unless otherwise indicated. The implementations described in the following exemplary embodiments do not represent all implementations consistent with the present disclosure. Rather, they are merely examples of apparatus and methods consistent with aspects of the disclosure as detailed in the appended claims.

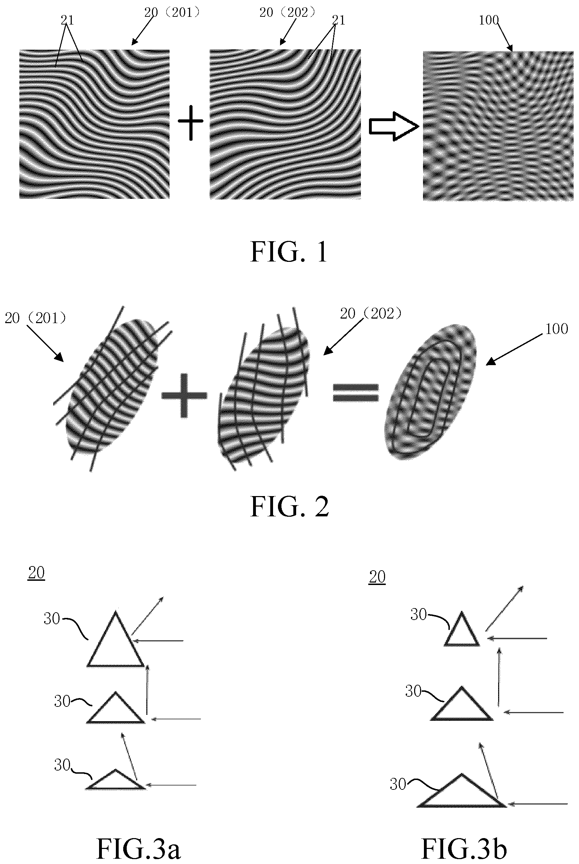

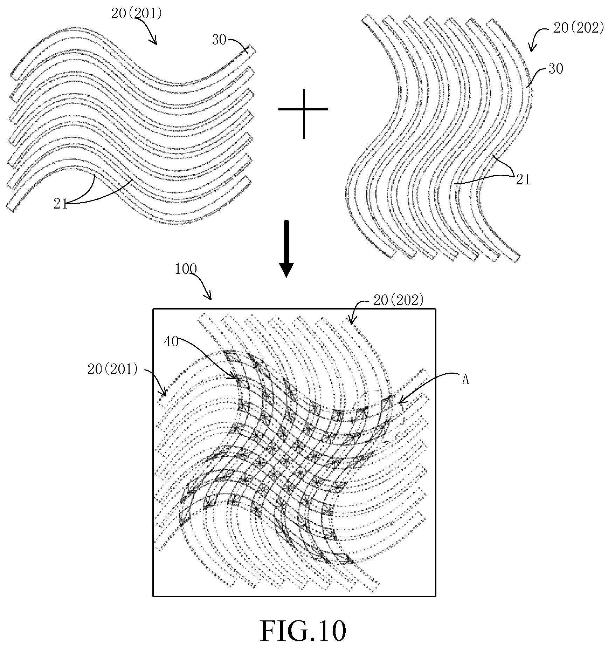

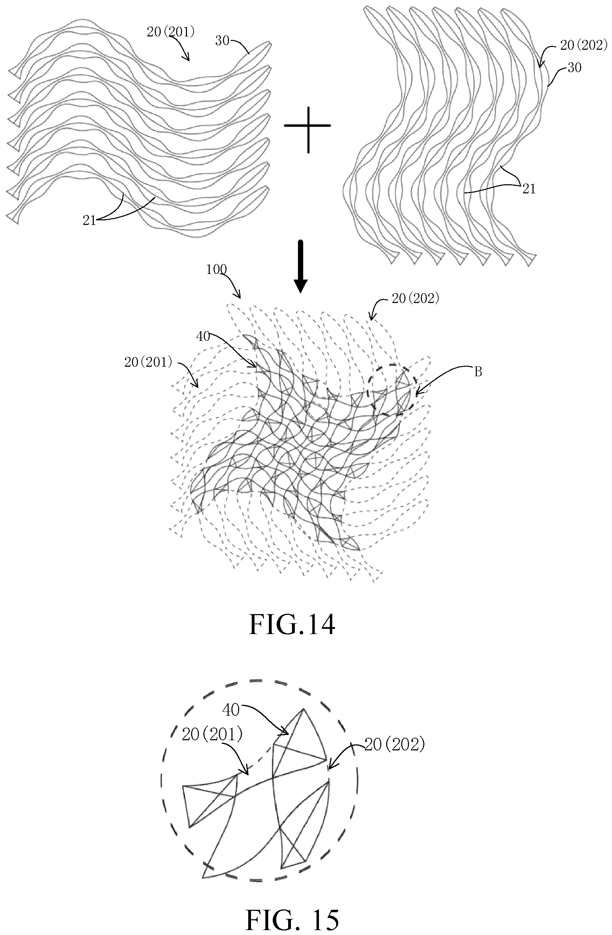

According to a first aspect of the present disclosure, a texture structure 100 is provided, which can be provided on various products to improve aesthetics. For example, the texture structure 100 can be provided on the glass cover of a mobile phone to present a desired three-dimensional effect. Specifically, referring to FIGS. 1 to 16, the texture structure 100 in the embodiment of the present disclosure includes a substrate 10 and a plurality of groups of gratings disposed on one side of the substrate 10. The plurality of groups of gratings 20 are cross-disposed on the surface of the substrate 10. The substrate 10 here can be a PC (Polycarbonate) sheet, a PET (polyethylene terephthalate) sheet, or a PC/PMMA (poly methyl methacrylate) composite plate material, the substrate 10 can also be a glass plate. The surface of the substrate 10 may be provided with two, three, four or more groups of gratings that are arranged crosswise. In the embodiment of the present disclosure, for convenience of description, two groups of gratings 20 will be described below as being crosswise arranged on the surface of the substrate 10. For example, the grating includes a first grating 201 and a second grating 202, but it should be understood that the number of grating groups in the embodiment of the present disclosure is not limited thereto. As shown in FIGS. 10 and 14, each of the plurality of groups of gratings 20 includes a plurality of grating units 21 arranged side by side and extending in the same direction. The adjacent grating units 21 may be arranged at intervals as shown in the figures, or may be Gap-free setup. Each of the grating units 21 in the embodiment of the present disclosure is configured to have a grating surface 30 inclined to the substrate 10 , and the grating surface 30 is used to refract light.

Through the above technical solution, the plurality of groups of gratings 20 are arranged in intersection, and the texture presented by the intersecting gratings 20 can be shared in the intersection area, so that the entire texture structure 100 has a closed and integrated light and shadow effect. Moreover, the grating unit 21 of each group of gratings 20 has an inclined grating surface 30, which can achieve a three-dimensional undulating feeling. Combined with the closed light and shadow effect, the entire texture structure can achieve the effect of closed sand dunes, thereby achieving good visual effects.

In the embodiment of the present disclosure, the plurality of groups of gratings 20 are configured to intersect so that the reflective surface of the texture structure 100 in any direction changes. The changing trend of the reflective surface refers to that at any angle of the texture structure 100 when observed, the reflective surfaces reflected by the texture structure 100 at this viewing angle are not all oriented in one direction, but the orientation of the reflective surfaces has a tendency to change. Referring to Figures 1 and 2, the lines across the grating 20 in Figure 2 represent the trend of light and shadow. In Figure 1, after combining the first grating 201 and the second grating 202, the texture structure 100 on the right side will be obtained. A texture structure 100 with a changing trend can be obtained through the combination of the two sets of gratings 20. For details, please refer to the light and shadow trend chart shown in Figure 2. When the first grating 201 and the second grating 202 in Figure 2 exist independently, they each rely on a facing surface to reflect light. After the first grating 201 and the second grating 202 are crossed and combined, the reflective surfaces change, and the two groups of the light sources reflected by the grating 20 are fused, and the final texture structure 100 reflects the fused light and shadow effect. This combination of gratings 20 in the embodiment of the present disclosure can obtain a gradual light and shadow effect, and the light and shadow presented by each grating 20 are combined at the intersection of the gratings 20, thereby producing a closed light and shadow effect.

According to an embodiment of the present disclosure, the tangent value of the angle between the grating surface 30 that is inclined to the substrate 10 and the surface of the substrate 10 may be between 1:150 and 20:1. For example, when the height of the photolithography is 20 µm, that is, when the height of the grating surface 30 is 20 µm, the corresponding width of the grating surface 30 can be between 1 µm and 3000 µm. This tangent value range can prevent the grating surface 30 from being too wide and causing only a plane effect, and the width of the grating surface 30 is too small to avoid presenting a sloping sand dune effect. For example, in some embodiments, in order to express the light and shadow flow effect, the tangent value of the angle between the grating surface of at least one set of gratings 20 and the surface of the substrate 10 can be set between 2:15 and 20:1, for example, the height of the surface 30 is 20 µm, and the corresponding width of the grating surface 30 is between 1 µm and 150 µm. In some embodiments, in order to have both the flow of light and shadow and to reflect the pattern of the arrangement of the gratings 20, the tangent value of the angle between the grating surfaces of at least one group of gratings 20 and the surface of the substrate 10 can be set to 1:150 to 2:15, for example, the height of the grating surface 30 is 20 µm, and the corresponding width of the grating surface 30 is between 150 µm and 3000 µm. In the embodiment of the present disclosure, the arrangement of these gratings can also be combined to obtain the desired texture effect. Among them, according to the setting of the photolithography height of 20 µm, the spacing between the grating units 21 of each group of gratings 20 can be set between 0 and 200 µm to ensure the texture expression effect.

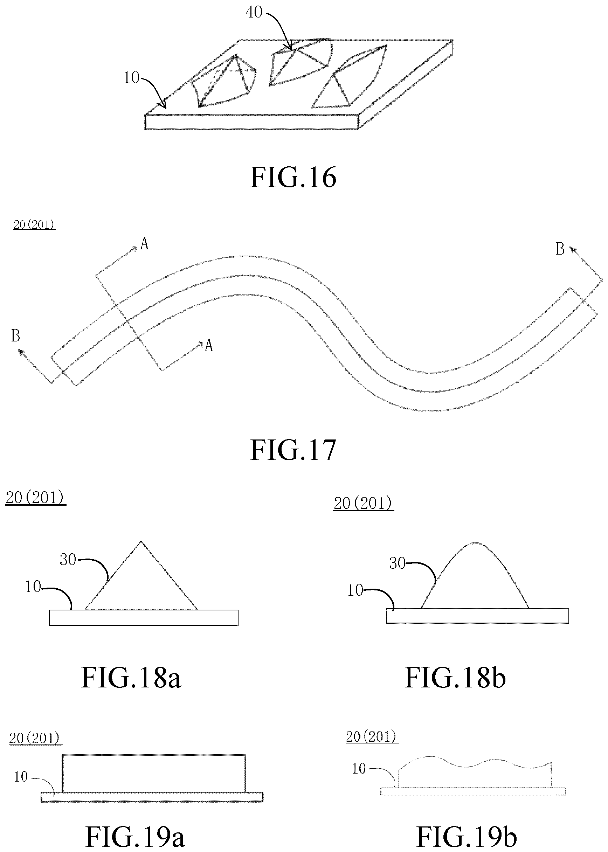

Figures 17 to 19 show embodiments of various shapes of the first grating 201, wherein Figures 18a and 18b are cross-sectional views A in Figure 17, representing the cross-section of the grating perpendicular to the extension direction, Figures 19a and Figure 19b is cross-sectional view B in Figure 17, showing a cross-section of the grating along the extending direction. Here, the vertex position of the first grating 201 may always be located at the center line position of the grating 20. In Figure 18a, the cross section of the grating 20 can be configured as a triangle; in Figure 18b, the cross section of the grating 20 is configured as an arcuate shape, that is, the grating 20 has an upwardly arched structure. In Figure 19a, the height of the grating 20 can be kept constant in the extension direction, that is, when the width of the grating 20 remains unchanged, the slope of the grating surface 30 of the grating 20 in the extension direction can be kept constant; in Figure 19b, the grating 20 can also be configured in an undulating shape, that is, the height of the grating 20 will change.

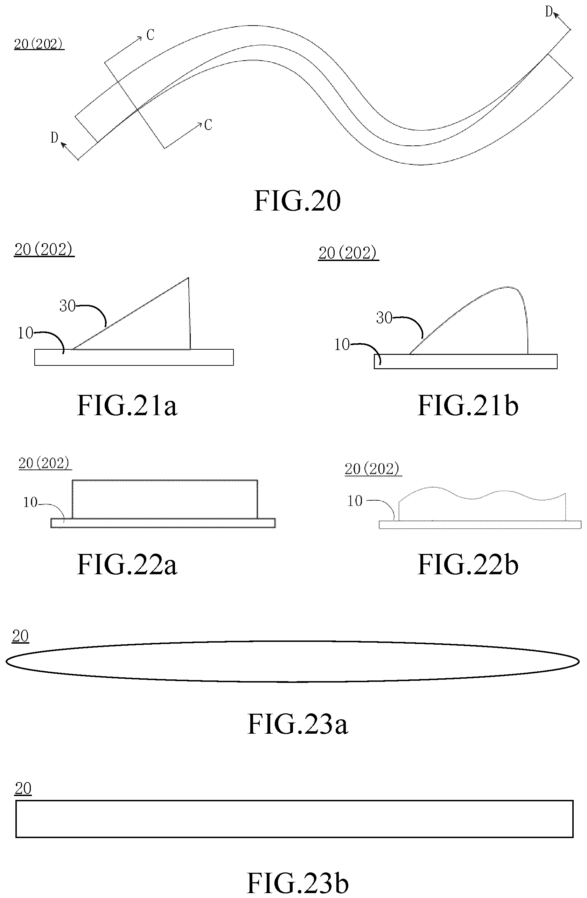

Figures 20 to 22 show embodiments of various shapes of the second grating 202. Figures 21a and 21b are cross-sectional views C in Figure 20, which represent the cross-section of the grating perpendicular to the extension direction. Figure 22 is Cross-sectional view D in Figure 20 shows the cross-section of the grating along the extending direction. Here, the vertex position of the second grating 202 may vary gradually in direction of extension of grating 20. For example, on the left side of FIG. 20, the apex of the grating 20 is aligned with one side of the grating 20, and on the right side of FIG. 20 , the apex of the grating 20 is aligned with the other side of the grating 20. Specifically, in Figure 21a, the cross section of the grating 20 can be configured as a triangle, and the triangle is configured as a right triangle; in Figure 21b, the cross section of the grating 20 is configured as an arc, that is, the grating 20 has an upwardly arched structure. The vertex of 20 is close to the right side of the cross section. In Figure 22a, similar to Figure 19a, the grating 20 can have a constant height in the extension direction; in Figure 22b, similar to Figure 19b, the grating 20 can also be configured in an undulating shape, that is, the height of the grating 20 will change.

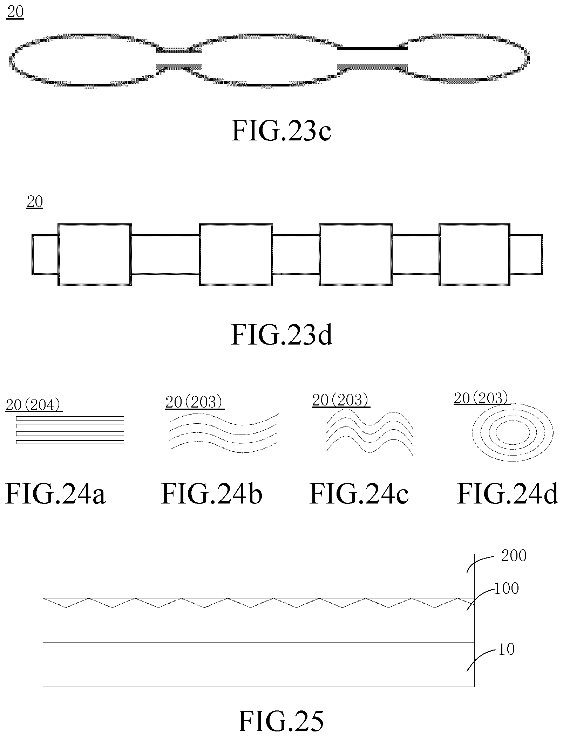

Figures 23a to 23d show various possible bottom surface shapes of the grating 20, that is, the shape of the contact surface of the grating 20 with the substrate 10. The bottom surface can be elliptical in shape as shown in Figure 23a, or rectangular in Figure 23b, or a special shape as shown in Figures 23c and 23d. This disclosure does not limit this, and various possible shapes are within the protection scope of the embodiments of this disclosure. It should be noted here that the structures of the first grating 201 and the second grating 202 are not limited to the above-mentioned combination methods. The bottom surfaces of various shapes can also be combined with cross sections along the extension direction and perpendicular to the extension direction to form gratings 20. The embodiments are not limited to the above-mentioned embodiments and those shown in the drawings, and can be adjusted and combined according to the actual desired effects.

In the embodiment of the present disclosure, the plurality of groups of gratings 20 may include curved gratings 203 extending in a curved manner or linear gratings 204 extending in a straight line, or may include both at the same time. Referring to Figures 24a to 24d, various possible extension directions of the grating 20 are shown. Figure 24a shows a linear grating 204 that extends straight, and Figures 24b to 24d show a curved grating 203 that extends in a curved manner. Specifically, Ground, Figure 24b shows an S-shaped grating, Figure 24c shows an M-shaped grating, Figure 24d shows an O-shaped grating, and the extending direction of the grating 20 shown in Figures 24a to 24d is only the description is illustrative and not intended to limit the disclosure.

In some embodiments, the plurality of sets of gratings 20 may include at least two sets of curved gratings 203 extending in a curved manner. Through the texture structure 100 obtained by the intersection of the two sets of curved gratings 203, a changing trend of the reflective surface in any direction can be obtained, that is, the effect of light and shadow changes is obtained, thereby achieving the visual effect of closed sand dunes. On this basis, one or more groups of linear gratings 204 or curved gratings 203 can be added arbitrarily.

In some embodiments, when the plurality of sets of gratings 20 only include two sets of gratings, and one or both sets of gratings are linear gratings 204 that extend straight, the slope of the grating surface 30 of the linear gratings 204 of the two sets of gratings can be set differently in the extension direction. For example, the slope of the grating surface 30 can be adjusted by changing the position of the vertex of the grating 20 in the width direction of the grating or by changing the height of the grating 20. By changing the slope of the grating surface 30 of the linear grating 204, it is also possible to obtain the changing trend of the reflective surface shown by the texture structure in any direction, that is, to obtain the effect of changing light and shadow, thereby achieving the visual effect of a closed sand dune.

Referring to Figures 3a and 3b, the reflection conditions of light on various grating surfaces 30 are shown. The arrows pointing to the left in the figures represent the paths of the incident light, and the arrows in other directions represent the paths of the reflected light. It can be seen from the figure that in Figure 3a, in order from top to bottom, the width of the grating 20 remains unchanged and the height gradually decreases (the slope of the grating surface 30 gradually decreases). According to the path of the reflected light, it can be seen that the light reflected to the human eye gradually decreases; in Figure 3b, in order from top to bottom, the height of the grating 20 remains unchanged and the width gradually increases (the slope of the grating surface 30 gradually decreases), and according to the path of the reflected light, it can be seen that the light reflected to the human eye also gradually became less and less. It can be seen from this that the smaller the slope of the grating surface 30 is, the less light is reflected, and the larger the slope of the grating surface 30 is, the more light is reflected. Based on this principle, after the plurality of groups of gratings 20 are intersected, for example, after the plurality of groups of gratings 20 are intersected through computer operating software, the intersection positions of the plurality of groups of gratings (such as two sets of gratings) can also be processed according to the actual required texture effects. That is, the slope of the grating surface at the intersection position is processed to obtain the expected texture effect.

Specifically, referring to Figures 4 and 5, the arrows in Figure 4 indicate the direction of the reflective surface of the grating. In Figure 4, the first grating 201 and the second grating 202 intersect to obtain a texture structure 100 in which the direction of the reflective surface changes. In this embodiment, the processing of the intersection after the gratings are crossed can be explained with reference to Figure 5. The thin solid line in Figure 5 represents the cross section of the first grating 201, and the dotted line represents the cross section of the second grating 202, the thick solid line represents the cross section of the intersection 40 obtained after processing the intersecting gratings. In the figure, the area where orthographic projections of the plurality of groups of gratings 20 overlap on the substrate 10 is configured as an overlapping area. The structure of the grating 20 corresponding to the overlapping area is configured as an intersection 40. The overlapping area has a plurality of position points A(x, y), only one point is shown in the figure, but it can be understood that the overlapping area is composed of several position points. The number of intersecting gratings 20 in the overlapping area is represented by n. The heights corresponding to the plurality of groups of intersecting gratings 20 at each position point A (x, y) are h1, h2,..., hn, respectively. The height of intersection portion 40 at the corresponding position point A (x, y) is represented by H. In one embodiment, the value of H may be the average height of the plurality of groups of gratings (h1+h2+...+hn)/n. As shown in Figure 5, the plurality of groups of gratings 20 include a first grating 201 and a second grating 202. The height of the first grating 201 corresponding to the position point A (x, y) is h1, and the height of the second grating 202 corresponding to the position point A (x, y) is h2, and the height corresponding to the intersection 40 at the corresponding position point A (x, y) is H=(h1+h2)/2. When designing, you can first intersect the two sets of gratings, and then cut the gratings in the overlapping area according to the preset height value of the intersection 40. For example, in Figure 5, cut off the grating outside the contour formed by the thick solid line and the substrate 10 to obtain the expected intersection 40. According to the experimental results, when the height of the intersection 40 is averaged as shown in Figure 5, the grating 20 and the intersection 40 can smoothly transition, thereby having a fused light and shadow effect as shown on the right side of Figure 4, to obtain a better dune effect.

In addition, referring to Figures 7 and 8, the expression methods of each parameter and each grating are the same as those of the previous embodiment. but what is different from the embodiment shown in Figures 4 and 5 is that in this embodiment, the value of the height H corresponding to the corresponding position point A (x, y) of the intersection 40 can be the smallest one among h1, h2,...,hn, that is, can be the smaller one among the heights of plurality of groups of gratings. For example, in FIG. 8, the height of the first grating 201 is h1, the height of the second grating 202 is h2, and h1<h2. In this embodiment, the height H of the intersection 40 may be h1. Similarly, the excess grating in the overlapping area can be cut in the same manner as above to obtain the expected intersection 40. According to the method of obtaining the intersection 40 as shown in FIG. 8, the light and shadow effect shown on the right side of FIG. 7 can be obtained. In other embodiments of the present disclosure, the height value of the intersection is not limited to this, and can be adjusted according to the actual texture effect required. For example, the intersection grating can be set any value between the lowest value and the highest value of the height of the overlapping area.

In the embodiment of the present disclosure, the intersection 40 may be configured as a pyramid or a prism, that is, the cross section of the intersection 40 may be configured as a triangle as shown in FIG. 8 or an irregular trapezoidal structure as shown in FIG. 5. It can be understood that the shape of the intersection portion 40 in the embodiment of the present disclosure is not limited thereto, and can be modified and adjusted according to the shape of the grating.

Since each group of gratings 20 has multiple grating units 21, the texture structure 100 formed after intersection may have multiple intersections 40. In the embodiment of the present disclosure, with reference to FIGS. 10 to 12 and 14 to 16, the shapes of the multiple intersection portions 40 can be set to be different. For example, the different shapes of the intersection portions 40 can be achieved by relying on the shape change of the grating itself, or the slope of the grating surface 30 of the intersection 40 can be changed by changing the vertex position of the intersection 40, or the size of the intersection 40 can be changed, so as to achieve refraction and reflection of light at different angles and different intensities, This achieves sand dune light and shadow with closed three-dimensional characteristics.

In addition, in the embodiment of the present disclosure, the intersection portion 40 can also be divided into multiple small bodies again, or the distance between the intersection portions 40 can be changed by cutting off the gratings between adjacent intersection portions 40 to modify the texture. The effect presented by the structure is adjusted to achieve the desired effect. For example, FIG. 6a shows the effect of cutting the texture structure 100 in FIG. 4, and FIG. 6 b shows the effect of raster cutting of the texture structure 100 in FIG. 4 to increase the gap between the intersections 40, Figure 6c shows the effect of cutting the texture structure 100 in Figure 6b again. As another example, FIG. 9a shows the effect of cutting the texture structure 100 in FIG. 7, and FIG. 9b shows the effect of raster cutting of the texture structure 100 in FIG. 7 to increase the gap between the intersections 40, Figure 9c shows the effect after cutting the texture structure 100 in Figure 9b again.

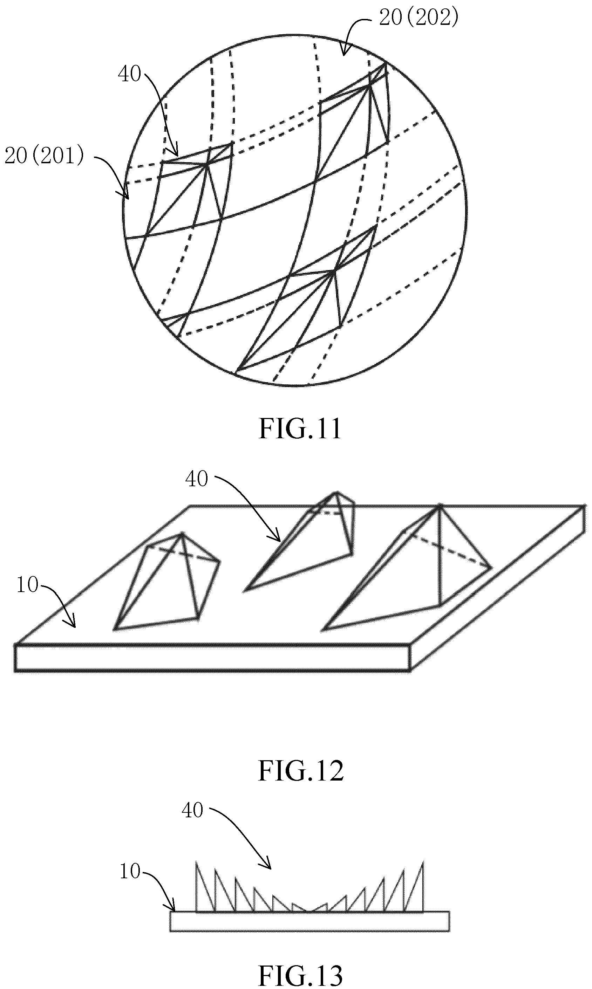

According to an embodiment of the present disclosure, with reference to Figures 10 to 12, after two sets of gratings intersect, the intersection 40 can be formed into a plurality of quadrangular pyramids, and the shapes of the quadrangular pyramids are different. Each quadrangular pyramid can also be divided into the shape shown in Figure 13. FIG. 13 shows a cross-sectional view after the intersection is divided. Figures 14 to 16 show the effect of another grating intersection. The intersection 40 here can be configured as an irregular pyramid structure. For example, the bottom edge of the pyramid can be a curve, the sides of a pyramid can be curved.

According to a second aspect of the present disclosure, a cover plate is also provided. The cover plate may include the above-mentioned texture structure 100. The cover plate has all the beneficial effects of the above-mentioned texture structure 100, which will not be described again here. Specifically, referring to FIG. 25, the cover plate may also include a color-filling layer 200 filled on the texture structure 100. For example, the texture structure 100 may be plated with a film layer of the same color. By utilizing the light and shadow of the undulating sand dunes in this disclosure, it may be made to appear different. The color change improves the aesthetics of the cover product.

According to a third aspect of the present disclosure, a mobile terminal is also provided. The mobile terminal includes the above-mentioned cover plate and has all the beneficial effects of the above-mentioned cover plate, which will not be described again here. The cover can be used as a back shell of the mobile terminal to improve the visual effect. Among them, mobile terminals can include mobile phones, tablets, laptops, etc.

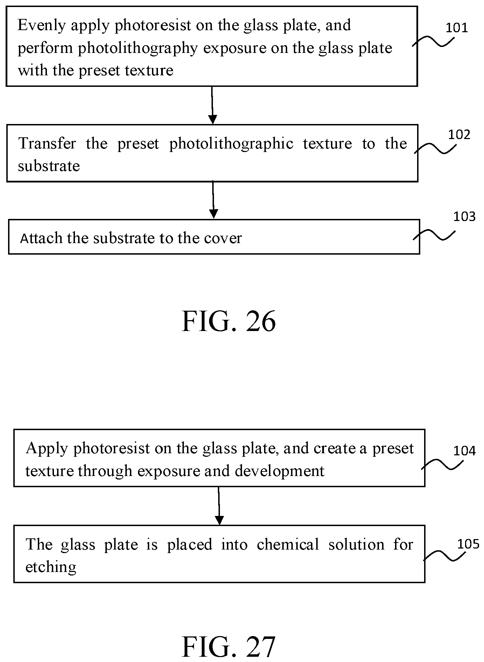

According to a fourth aspect of the present disclosure, a method for preparing a cover plate is also provided. Referring to Figure 26, the method includes: in step 101, evenly apply photoresist on the glass plate, and perform photolithography exposure on the glass plate with the preset texture. The preset texture here is the texture obtained by the above-mentioned plurality of groups of gratings 20 after cross-processing. The designed preset texture data can be transferred to the computer, and then photolithography exposure is performed on the glass plate according to the data; in step 102, transfer the preset photolithographic texture to the substrate 10. For example, after step 101, the texture after step 101 is developed, dried, and plasma cleaned, and then transferred to the substrate 10 by UV transfer; And in step 103, the substrate 10 is bonded to the cover plate through processes such as coating, printing, cutting, and lamination, thereby obtaining a cover plate with a preset texture. As mentioned above, the substrate 10 can be one of PC sheet, PET sheet, and PC/PMMA composite sheet.

Typically, the cover itself may include a glass plate, which may be constructed directly as the substrate 10 of the textured structure 100. Referring to Figure 27, in the embodiment of the present disclosure, another method of preparing a cover plate may include: in step 104, spreading photoresist on the glass plate, and producing texture structure from pre-stored texture data in the computer through exposure and development; and in step 105, place the glass plate into a chemical etching tank for etching. Due to the protective effect of photoresist on glass, areas with thicker resist will resist etching for a longer time, while areas with thinner resist will resist etching for shorter periods of time. The glass of the substrate 10 will leak out before the thicker resist. Therefore, the glass placed in the etching tank will be uneven. With a reasonable etching time, the texture can be copied to the glass plate of the cover plate, thereby forming the texture structure 100 in the embodiment of the present disclosure and obtaining the desired cover plate.

The preparation method of the cover plate in the embodiment of the present disclosure may also include: coating, spraying or printing the cover plate provided with the texture structure, thereby forming a cover plate product with a gradient color.

The preferred embodiments of the present disclosure have been described in detail above with reference to the accompanying drawings. However, the present disclosure is not limited to the specific details in the above-mentioned embodiments. Within the scope of the technical concept of the present disclosure, the technical solution of the present disclosure can be simplified in various ways, these simple modifications all belong to the protection scope of the present disclosure.

In addition, it should be noted that each of the specific technical features described in the above-mentioned specific embodiments can be combined in any suitable manner without conflict. In order to avoid unnecessary repetition, this disclosure describes various possible combinations. The combination method will not be further explained.

In addition, any combination of various embodiments of the present disclosure can also be carried out, and as long as they do not violate the idea of the present disclosure, they should also be regarded as the contents disclosed in the present disclosure.

## Claims

1. A texture structure (100), comprising:
substrate (10); and
a plurality of groups of gratings (20) arranged on one side of the substrate (10), the plurality of groups of gratings (20) being arranged on the surface of the substrate (10) in a crisscross pattern, each of the plurality of groups of gratings (20) comprising a plurality of grating units (21) arranged side by side and extending in the same direction, and each of the plurality of grating units (21) being configured to have a grating surface (30) inclined to the substrate (10).

2. The texture structure (100) according to claim 1, wherein the plurality of groups of gratings (20) are configured to intersect so that a reflective surface of the texture structure (100) in any direction exhibits a changing trend.

3. The texture structure (100) according to claim 1 or 2, wherein the plurality of groups of gratings (20) comprise:
curved extended curved grating (203) and/or
straight line extending linear grating (204).

4. The texture structure (100) according to any one of claims 1-3, wherein the plurality of groups of gratings (20) comprise at least two groups of curved extended curved gratings (203).

5. The texture structure (100) according to any one of claims 1-3, wherein the plurality of groups of gratings (20) include two groups of gratings (20), and at least one of the two groups of gratings (20) is a straight-line extending linear grating (204), the slope of the grating surface (30) of the linear grating (204) differs in the extension direction.

6. The texture structure (100) according to any one of claims 1-5, wherein the cross section of the grating (20) perpendicular to the extension direction is configured in a triangular or arcuate shape.

7. The texture structure (100) according to any one of claims 1-6, wherein the tangent value of the angle between the grating surface (30) and the surface of the substrate (10) is between 1:150 and 20:1.

8. The texture structure (100) according to claim 7, wherein the tangent value of the angle between the grating surface (30) of at least one set of gratings (20) and the surface of the substrate (10) is between 2:15 and 20:1, and/or,
the tangent value of the angle between the grating surface (30) of at least one set of gratings (20) and the surface of the substrate (10) is between 1:150 and 2:15.

9. The texture structure (100) according to any one of claims 1-8, wherein an area where orthographic projections of the plurality of groups of gratings (20) overlap on the substrate (10) is configured as an overlapping area, and the structure of the grating (20) corresponding to the overlapping area is configured as an intersection portion (40), the overlapping area has a plurality location points A (x, y) , the heights corresponding to the plurality of groups of intersecting gratings (20) at each position point A (x, y) are h1, h2 ,..., hn respectively, the corresponding height H to the intersection (40) at the corresponding position point A (x , y) is (h1 +h2 +...... +hn )/n, or the height H corresponding to the intersection at the corresponding position point A(x, y) is the smallest one among h1, h2,...,hn, where n is the number of the plurality of gratings (20) intersecting in the overlapping area.

10. The texture structure (100) according to claim 9, wherein the intersection (40) is configured as a pyramid or a prism.

11. The texture structure (100) according to claim 9 or 10, wherein the texture structure (100) has a plurality of intersections (40), and the shapes of the plurality of intersections (40) are different.

12. A cover plate, wherein comprising the texture structure (100) according to any one of claims 1-11.

13. A mobile terminal, wherein comprising a cover plate according to claim 12.

14. A method for preparing a cover plate, wherein the cover plate comprising the texture structure (100) according to any one of claims 1-11, and the preparation method includes:
evenly applying photoresist on the glass plate, and performing photolithography exposure on the glass plate with the preset texture;
transferring the preset photolithographic texture to the substrate (10); and
attaching the substrate (10) to the cover.

15. The preparation method according to claim 14, wherein the substrate (10) includes one of PC sheets, PET sheets, and PC/PMMA composite sheets.

16. A method for preparing a cover plate, wherein the cover plate comprises a glass plate configured as the substrate (10) and the textured structure (100) according to any one of claims 1-11, the preparation method comprising:
apply photoresist on the glass plate and create a preset texture through exposure and development; and
the glass plate is placed into chemical solution for etching.
